# EUROPEAN PATENT APPLICATION

(11) **EP 1 244 145 A2**
(43) Date of publication of application: **25.09.2002**
(21) Application number: 02004852.6
(22) Date of filing: 04.03.2002
(51) Int. Cl.: H01L 23/427, F28D 15/02

(54) **Press formed two-phase cooling module and method for making same**

(30) Priority: 20.03.2001 US 812602
(71) Applicant: MOTOROLA, INC., Schaumburg, IL 60196 (US)
(72) Inventor: Estes, Kurt Arthur, Lake Zurich, Illinois 60047 (US)
(74) Representative: Gibson, Sarah Jane

(57) **Abstract**

The two-phase cooling module (200) for electronic components includes a first cooling chamber member (210) press formed as a unitary member having an offset surface and a perimeter surface. A second cooling chamber member(212, 600) , such as a flat sheet, serves as cooling chamber member and is brazed to the perimeter surface. A non-integral support member (500) is interposed between the first cooling chamber member and the cover (600) and is located within the cooling cavity. In an alternative embodiment, the cooling cavity is defined by two cooling chamber members, each of which are press formed as separate unitary members (210, 212) each having offset surfaces and corresponding perimeter surfaces.

## Description

### Field Of The Invention

The invention relates generally to cooling modules for electronic components, and more particularly to two-phase cooling modules (TPM) having one or more vapor/liquid cavities.

### Background Of The Invention

Recently, with an increase in component density due to advances in electronic packaging techniques of integrated circuit elements, the density of heat generation and electronic equipment has greatly increased. As a result, the heat dissipation requirements within advanced electronic equipment have become increasingly more severe.

Air cooled systems are commonly used to cool electronic equipment. Now, efforts to shrink electronic assemblies have placed multiple high heat flux parts within close proximity to each other, exceeding the capacity of present air cooled technology. Single phase liquid cooled systems are commonly used for cooling electronic components. Liquid cooling requires external condensing coils and/or significant plumbing requirements. Thus, liquid cooled systems are comparatively larger, heavier, and more costly.

The prior known systems for cooling avionics equipment, for example, use heat pipes. The heat pipe is a sealed thermodynamic system relying on internal evaporation and condensation cycles. It typically includes an enclosure, a wicking material lining internal walls in the enclosure, and a wicking fluid for saturating the wick. One end of the heat pipe is called the evaporator and serves to absorb heat energy. Vapor formed in an evaporator is transported to the other end of the heat pipe, called the condenser, and the heat energy is released. The liquid is returned to the evaporator through a wick structure on the inside of the heat pipe completing the process. The performance of this heat pipe is highly dependent on the operating temperature, wick dry out and internal generation of non-condensable gases.

Other cooling techniques are also known. For example, two phase cooling modules are known, such as those described, for example, in U.S. Patent No. 5,924,482, entitled "Multi-Mode, Two Phase Cooling Module," having as inventors Edwards et al., and owned by instant assignee, and also U.S. Patent No. 5,937,937, entitled "Heat Sinking Method for Removing Heat from a Plurality of Components," having inventors Schembey et al. and owned by instant assignee. Such two-phase cooling modules typically include a cavity that includes heat removal regions and a liquid reservoir region. For example, the cavity may be filled with a cooling liquid such as water, alcohol, perfluorinated dielectric liquid, or other phase change liquid. One or more electronic components are mounted onto an external surface of the module. Heat exchange fins are also typically mounted to an external surface of the module. As electronic components generate heat, over time the cooling liquid becomes heated to the point where it reaches a vapor phase. As the vapor rises in the cavity, it condenses along internal surfaces of the cavity. This heat exchange along with the external fins can greatly improve the heat dissipation for electronic components mounted to the external surfaces of the cavity.

Typically, such two-phase modules are made from aluminum. However, the manufacturing process typically used includes milling or machining out a portion of a block of aluminum to form the vapor/liquid cavity. Two such pieces are milled and/or one large piece is milled out with a flat cover being brazed on top of the milled portion to form the liquid/vapor cavity. Machining time is relatively expensive and increases the cost of manufacture. In addition, the material of the block of aluminum that is milled out is scrapped resulting in large amounts of wasted aluminum, also resulting in increased costs. Such two phase modules may also include a non-integral internal support member, such as lanced offset fin stock that is inserted in the interior of the liquid/vapor cavity to provide structural support since the walls of the cavity are typically on the order of .7 mm. thick. Lanced offset fins, as known in the art, include openings therein which allow both latitudinal and longitudinal flow of air (and hence liquid within the cavity). In addition, the surface area of the lanced offset fin stock provides a heat exchange surface within the liquid/vapor cavity. However, such milled two phase modules can be excessively high priced and lengthy to manufacture.

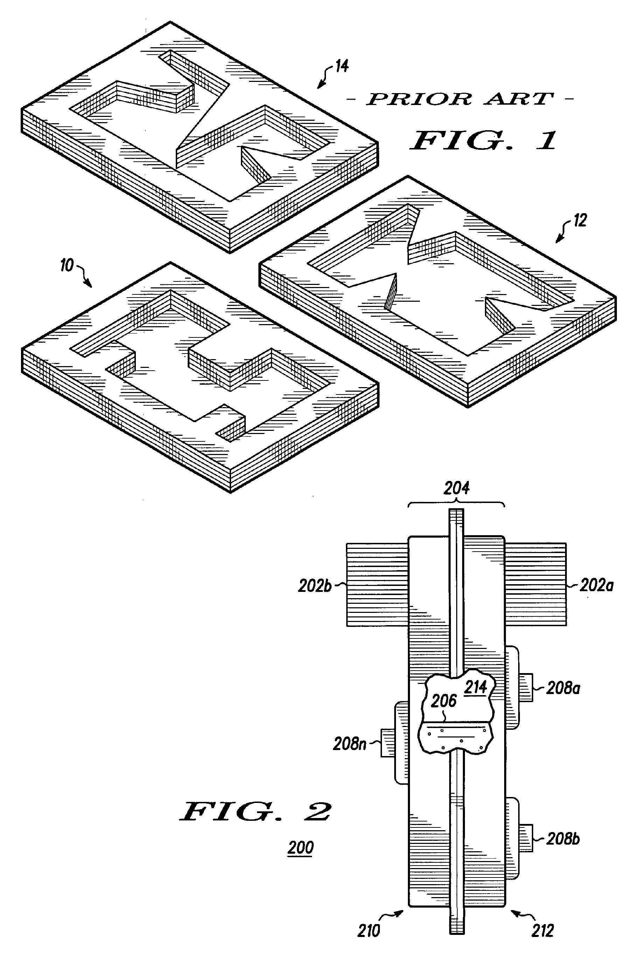

An alternative manufacturing technique has been used to manufacture two phase modules. For example, aluminum laminate sheets are stacked to form the liquid/vapor cavity. Typically, the laminated sheets include protrusions extending inwardly within the cavity as shown, for example, in FIG. 1. As shown the laminate sheet 10, includes protrusions that may be uniform among all sheets that are stacked together. Alternatively, as shown in laminate sheets 12 and 14, they may have nonuniform protrusions extending inwardly but when stacked have common points of contact which form structural support and may be used, for example, for receiving threaded bosses or may be used for other purposes. Once the sheets with the protrusions are stacked, a top cover and bottom cover are used to form an enclosed liquid/vapor cavity. Subsequently, the assembly is put through a brazing process. The sheets with the protrusions may be, for example, aluminum impregnated with a braze alloy or may be brazed, as known in the art, using a brazing foil between the laminates. Such a manufacturing technique can reduce costs since the sheets with the protrusions are typically punched out which avoids the time consuming operation of milling blocks of aluminum. However, such two phase modules may still not have enough structural support. In addition, the protrusions can also result in additional wasted aluminum since the resulting interior portion of sheets is divided such that they are not typically conducive for reuse to manufacture additional two phase modules.

Accordingly, a need exists for a cost effective and structurally sound two phase module and method of making the same.

### Brief Description Of The Drawings

FIG. 1 illustrates laminate sheets with protrusions used to make two-phase cooling modules in accordance with prior art methods;
FIG. 2 is a side view of a two-phase cooling module made by press forming a liquid vapor cavity in accordance with one embodiment of the invention;
FIG. 3 is a graphical representation illustrating a cooling chamber member having an offset first surface and a perimeter surface as formed from a flat sheet in accordance with one embodiment of the invention;
FIG. 4 is a side view illustrating an assembled two-phase cooling module having two cooling chamber members formed as one half of a liquid vapor cavity in accordance with one embodiment of the invention;
FIG. 5 is an exploded perspective view illustrating a two-phase cooling module with a support member inserted within the cooling cavity in accordance with one embodiment of the invention; and
FIG. 6 is a side view illustrating an alternative embodiment of a two-phase cooling module in accordance with one embodiment of the invention.

### Detailed Description Of The Preferred Embodiment

Briefly, a two-phase cooling module for electronic components includes a first cooling chamber member press formed as a unitary member having an offset surface and a perimeter surface. The offset surface defines at least a portion of a cooling cavity. A second cooling chamber member, such as a flat cover, serves as a cooling chamber member and is brazed to the perimeter surface. A non-integral support member is interposed between the first cooling chamber member and the cover and is located within the cooling cavity. In an alternative embodiment, the cooling cavity is defined by two cooling chamber members, each of which are press formed as separate unitary members each having offset surfaces and corresponding perimeter surfaces.

A method for making a two-phase cooling module includes press forming a first sheet, such as an aluminum sheet, to form the offset surface (first cavity surface) and a first perimeter surface. The method also includes press forming a second sheet, such as a sheet of aluminum, to form a corresponding second cavity surface and a second perimeter surface, and brazing a support member to at least one of the first and second cavity surfaces to form the two-phase cooling module.

FIG. 2 illustrates a two-phase cooling module 200 for electronic components in accordance with one embodiment of the invention. The two-phase cooling module 200 includes heat exchange fins 202a and 202b that are mounted on an external surface of the two-phase cooling module 200 and in particular on an external surface of a cooling chamber 204 which contains cooling liquid 206, such as water, alcohol, perfluorinated dielectric liquid, or other phase change liquid. One or more electronic components 208a-208n are mounted to one or both sides of the cooling chamber 204 on external surfaces of the cooling chamber 204. In this embodiment, the two-phase cooling module 200 includes a first cooling chamber member 210 and a second cooling chamber member 212. The first and second cooling chamber members 210 and 212 are sealed to form a cooling cavity 214 that contains the cooling liquid 206. The first and second cooling chamber members 210 and 212 are brazed together to form a sealed cooling cavity.

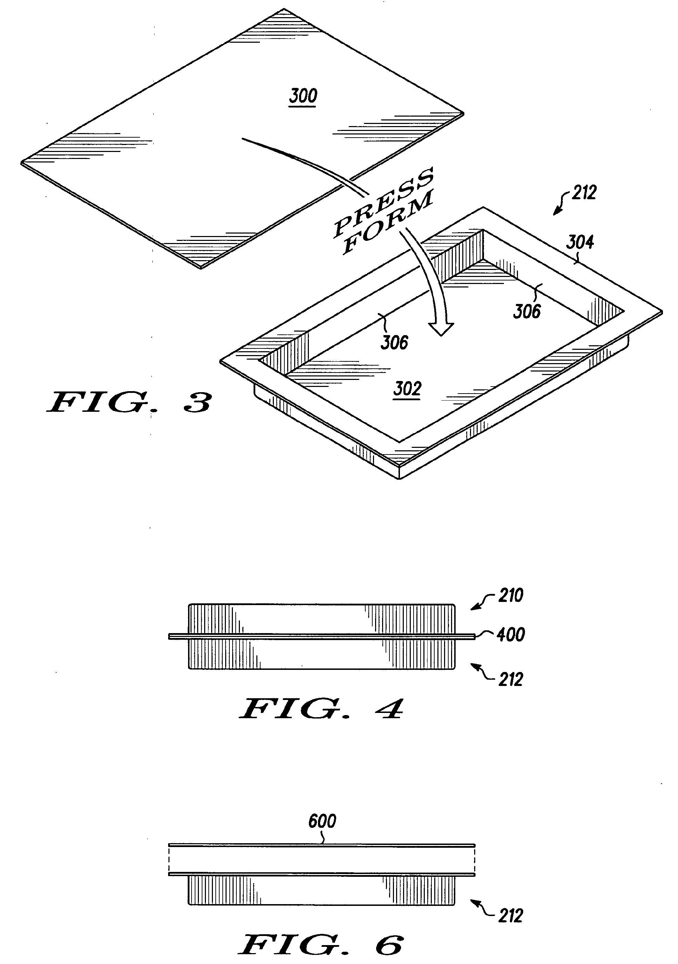

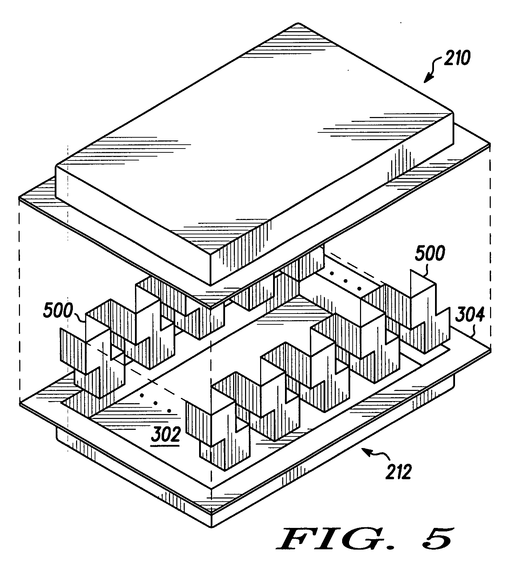

Referring to FIGs. 2-5, cooling chamber 212 is shown as being press formed from a sheet 300, such as a sheet of aluminum, aluminum alloy, or other suitable material. The sheet 300 may contain a brazing alloy impregnated in the aluminum or may be of a type of material such that a brazing foil is used during a brazing process to seal the two cooling chamber members 210 and 212 together. As shown in this example, the brazed sheet may be, for example, 0.7 mm thick or any other suitable thickness. Each of the cooling chamber members 210 and 212 are formed as unitary members from separate sheets. Each of the cooling chamber members 210 and 212 have offset surfaces 302 that are offset from a perimeter surface 304. The offset surfaces of each of the cooling chamber members define the cooling cavity 214. Internal sidewalls 306 are considered part of the offset surface that defines the cooling cavity. An outer portion of the perimeter surface 204 serves as the brazing surface used to braze the first and second cooling chamber members 210 and 212 together to form a sealed cooling cavity. Accordingly, a braze joint 400 (FIG. 4) is formed when the two cooling chamber members 210 and 212 are brazed together.

Referring to FIG. 5, a non-integral support member 500 is interposed between the first cooling chamber member 210 and the second cooling chamber member 212 and is located within the cooling cavity 214. The non-integral support member 500 may be any suitable support member or structure that provides structural support between the cooling chamber member 210 and cooling chamber member 212. Accordingly, the non-integral support member may be one or more bosses or other suitable structures. In a preferred structure, the non-integral support member 500 includes liquid pass through channels that allow the cooling liquid to flow in longitudinal and latitudinal directions or in any other suitable directions to allow suitable liquid flow through the support member 500 while still providing structural support. A preferred structure of the non-integral support member is a lanced offset fin that is brazed to internal surfaces of the first and second cooling chamber member. The lanced offset fin may be any suitable lanced offset fin stock such as the type available for example from Robinson Fin Machines Inc., Kenton, Ohio. Where the non-integral support member 500 is lanced offset fin stock, it may be suitably sized to fit within the cooling cavity. The non-integral support member 500 is coupled to contact an internal cavity surface such as the offset surfaces of both the first and second cooling chamber members 210 and 212.

As shown, the cooling chamber members 210 and 212 each form one half of a box like cooling cavity. However, it will be recognized that any suitable shape may be used. Moreover, it will be recognized that each cooling chamber may be formed as more or less than one half of the cooling cavity. Also, multiple cooling cavities may be formed.

FIG. 6 illustrates a cooling chamber cover 600 is made of a flat sheet as opposed to a pressed unitary member having an offset surface and a perimeter surface. Accordingly, in this embodiment, the two-phase cooling module is made from a flat cooling chamber cover and a cooling chamber member that is press formed as a unitary member and having an offset surface and a perimeter surface as described above. The offset surface defines the cooling cavity and an internal surface of the cooling chamber cover defines a wall of the cooling cavity. The cooling chamber cover 600 is brazed to at least a portion of the perimeter surface of the cooling chamber member 212.

To make the two-phase cooling module shown, for example, in FIGs. 2-5, a first sheet, such as a sheet of aluminum or aluminum alloy or any other suitable material, is press formed to form a unitary first cavity surface and a perimeter surface, namely, the cooling chamber member. In addition, another cooling chamber member is formed by press forming a second sheet to form a corresponding unitary second cavity surface and a second perimeter surface. Once the two unitary cooling chamber members are formed, a support member is brazed to at least one of the first and second cavity surfaces associated with one of the cooling chamber members to form structural support. Preferably, the brazing operation is performed once with the non-integral support member being placed inside the cooling cavity and wherein the cooling chamber members are brazed together along perimeter surfaces and the support member is brazed to both of the cavity surfaces internal to the two-phase cooling module. Where the sheets contain a brazing alloy, brazing foil may not be needed to facilitate the brazing operation. However, where materials are used that require brazing foil, a window-shaped brazing foil pattern may be used and can be placed on the perimeter surface of one of the cooling chamber members to allow perimeter surfaces of the cooling chamber members to be brazed to form the brazing joint. Once the cooling cavity is formed, a fill port is put in a surface of the module to allow the cooling liquid to be placed within the module. This may include, for example, drilling or punching holes within the cooling module as known in the art.

The above press formed two-phase cooling module can reduce the amount of wasted aluminum as well as speed up the manufacturing process via the press forming operation. Moreover, the afore-described two-phase cooling module avoids the need for stamping laminate sheets with protrusions therein. Other advantages will be recognized by those of ordinary skill in the art.

Moreover, it should be understood that the implementation of other variations and modifications of the invention in its various aspects will be apparent to those of ordinary skill in the art, and that the invention is not limited by the specific embodiments described. It is therefore contemplated to cover by the present invention, any and all modifications, variations, or equivalents that fall within the spirit and scope of the basic underlying principles disclosed and claimed herein.

## Claims

1. A two phase cooling module for electronic components comprising:
a first cooling chamber member press formed as a unitary member having a first offset surface and a first perimeter surface; and
a second cooling chamber member, operatively sealed with the first cooling chamber, press formed as a unitary member having a second offset surface and a second perimeter surface such that the first and second offset surface define a cooling cavity.

2. The module of claim 1 including a non integral support member interposed between the first cooling chamber member and the second cooling chamber member and located within the cooling cavity.

3. The module of claim 2 wherein the non-integral support member is a member configured as a lanced offset fin that is brazed to the first and second cooling chamber member.

4. The module of claim 2 wherein the non-integral support member is operatively coupled to contact an internal cavity surface associated with the both the first and second offset surfaces.

5. The module of claim 1 including a two phase cooling liquid and electronic components operatively coupled to an external surface of the module.

6. A two phase cooling module for electronic components comprising:
a cooling chamber cover; and
a cooling chamber member, operatively sealed with the cooling chamber cover, press formed as a unitary member and having an offset surface and a perimeter surface such that the offset surface defines a cooling cavity.

7. The module of claim 6 including a non integral support member interposed between the first cooling chamber cover and the cooling chamber member and located within the cooling cavity.

8. The module of claim 7 wherein the non-integral support member is a member configured as a lanced offset fin that is brazed to the cooling chamber cover and to at least a portion of the offset surface of the cooling chamber member.

9. The module of claim 6 including a two phase cooling liquid and electronic components operatively coupled to an external surface of the module.

10. A method for making a two phase cooling module for electronic components comprising the steps of:
press forming a first sheet to form a unitary first cavity surface and a first perimeter surface;
press forming a second sheet to form a corresponding unitary second cavity surface and a second perimeter surface; and
brazing a support member to at least one of the first and second cavity surfaces.
